# EUROPEAN PATENT APPLICATION

(11) **EP 4 718 494 A1**
(43) Date of publication of application: **01.04.2026**
(21) Application number: 25199958.7
(22) Date of filing: 03.09.2025
(51) Int. Cl.: H01J 37/32

(54) **SUBSTRATE PROCESSING EQUIPMENT AND ICP ANTENNA MODULE THEREFOR**

(30) Priority: 27.09.2024 KR 20240131824
(71) Applicant: Korea Institute of Fusion Energy, Daejeon 34133 (KR)
(72) Inventor: KIM, Jongsik, Jeollabuk-do (KR)
(74) Representative: ABG Intellectual Property Law, S.L.

(57) **Abstract**

The present invention relates to a substrate processing apparatus, and more particularly, to a substrate processing apparatus that performs substrate processing by forming plasma with an induced electric field, and an ICP antenna module used therein. The present invention discloses an ICP antenna module comprising: a first antenna coil part, one end of which is connected to a matcher; a second antenna coil part, the other end of which is grounded; and a phase changing circuit part, one end of which is connected to the other end of the first antenna coil part and the other end of which is connected to one end of the second antenna coil part, wherein the phase changing circuit part changes a phase of a first current flowing through the first antenna coil part to a second current having a phase opposite to the first current.

## Description

### BACKGROUND

The present invention relates to a substrate processing apparatus, and more particularly, to a substrate processing apparatus that performs substrate processing by forming plasma with an induced electric field, and an ICP antenna module used therein.

CPUs, memory devices, display panels, and the like are generally manufactured through so-called semiconductor processes such as etching and deposition, and semiconductor processes can be variously performed depending on the type of process, such as CVD, PVD, etc.

Meanwhile, in performing a semiconductor process, i.e., substrate processing, it can be carried out using plasma, and a substrate processing apparatus that performs substrate processing can be variously configured according to the plasma formation method.

For example, as in Patent Document 1, a substrate processing apparatus that performs substrate processing by forming plasma using an induced electric field is proposed.

A substrate processing apparatus using an induced electric field, as in Patent Document 1, is configured to include a process chamber in which a substrate support for placing a substrate is installed, a dielectric window installed on the upper side of the process chamber, and one or more antennas installed on the upper part of the dielectric window. By applying RF power to one end of the antenna and grounding the other end, plasma is formed under the dielectric window to perform substrate processing.

Meanwhile, the performance of the substrate processing apparatus depends on the uniformity of substrate processing on the substrate surface, and the uniformity of substrate processing is greatly influenced by the structure of the antenna.

(Patent Document 1) KR 10-2023-0056817 A

### SUMMARY

An object of the present invention is to provide a substrate processing apparatus and an ICP antenna module used therein, which are capable of performing uniform substrate processing when carrying out substrate processing using an induced electric field, in consideration of the above-mentioned points.

The present invention, created to achieve the above object, presents an ICP antenna module comprising: a first antenna coil part 110, one end 111 of which is connected to a matcher 92; a second antenna coil part 120, the other end 122 of which is grounded; and a phase changing circuit part 300, one end 301 of which is connected to the other end 112 of the first antenna coil part 110 and the other end 302 of which is connected to one end 121 of the second antenna coil part 120, wherein the phase changing circuit part changes the phase of a first current flowing through the first antenna coil part 110 with a second current having a phase opposite to the first current.

The first antenna coil part 110 and the second antenna coil part 120 may be configured with coils 113, 123, wherein one end 111 and the other end 112 of the first antenna coil part 110 are disposed opposite to one end 121 and the other end 122 of the second antenna coil part 120, and are wound in the same direction with a vertical gap.

The first antenna coil part 110 and the second antenna coil part 120 may form a helical shape with the same center and radius.

The ICP antenna module may further include one or more outer antenna parts 200 forming an outer helical shape with a radius larger than the radius of the first antenna coil part 110 and the second antenna coil part 120.

The outer antenna part 200 may include n outer antenna coils 210, 220, wherein the positions of their one ends are arranged with a phase difference of 360°/n (where n is a natural number of 2 or more) along the circumferential direction.

The outer antenna coils 210, 220 may include: a first antenna coil member 211, 221, one end of which is connected to a branch power application member 823 and has a first circumferential angle θ1; a second antenna coil member 212, 222, one end of which is connected to the other end of the first antenna coil member 211, 221, is installed lower than the first antenna coil member 211, 221, and has a second circumferential angle θ2; and a third antenna coil member 213, 223, one end of which is connected to the other end of the second antenna coil member 212, 222, is installed higher than the second antenna coil member 212, 222, and has a third circumferential angle θ3.

The phase changing circuit part 300 may include: a first capacitor 310 connecting the other end 112 of the first antenna coil part 110 and one end 121 of the second antenna coil part 120; and a second capacitor 320 and a third capacitor 330 connected in series between the other end 112 of the first antenna coil part 110 and one end 121 of the second antenna coil part 120, in parallel with the first capacitor 310, wherein a connecting conductive member 891 connecting the second capacitor 320 and the third capacitor 330 may be grounded by a grounding conductive member 824.

The first capacitor 310 and the second capacitor 320 are connected to a first conductive member 893 connected to the other end 112 of the first antenna coil part 110, and the other end of the third capacitor 330, one end of which is connected to the connecting conductive member 891, and the other end of a third conductive member 895, one end of which is connected to the other end of the first capacitor 310, may be connected by a second conductive member 894 connected to one end 121 of the second antenna coil part 120.

The connecting conductive member 891, the first conductive member 893, the second conductive member 894, and the third conductive member 895 may be formed by a metal plate.

One end 111 of the first antenna coil part 110 may be connected to a power application member 821 that extends toward the center of the helical shape forming the antenna coil part 110.

### BRIEF DESCRIPTION OF THE FIGURES

FIG. 1 is a cross-sectional view showing a substrate processing apparatus according to the present invention.
FIG. 2 is a cross-sectional view showing an ICP antenna module of the substrate processing apparatus of FIG. 1.
FIG. 3 is a perspective view showing a part of the ICP antenna module shown in FIG. 2.
FIG. 4a is a partially exploded perspective view showing the configuration of antenna coils of the ICP antenna module shown in FIG. 3.
FIG. 4b is a partially exploded perspective view showing the configuration of a phase changing circuit part of the ICP antenna module shown in FIG. 3.
FIG. 4c is an exploded perspective view of the phase changing circuit part shown in FIG. 4b.
FIG. 5 is a plan view of the ICP antenna module shown in FIG. 2.
FIG. 6 is a circuit diagram of the ICP antenna module according to the present invention.

### DETAILED DESCRIPTION

Hereinafter, a substrate processing apparatus and an ICP antenna module used therein according to the present invention will be described with reference to the accompanying drawings.

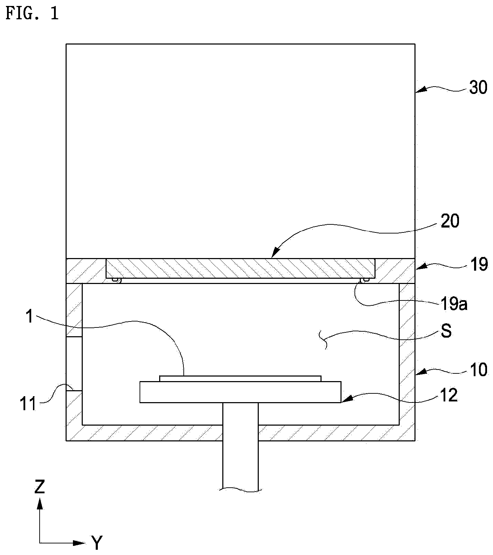

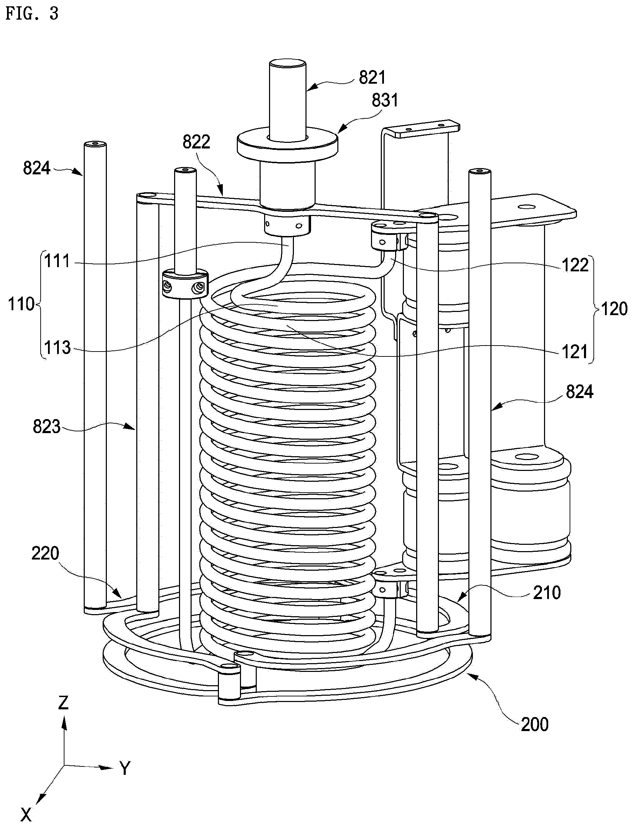

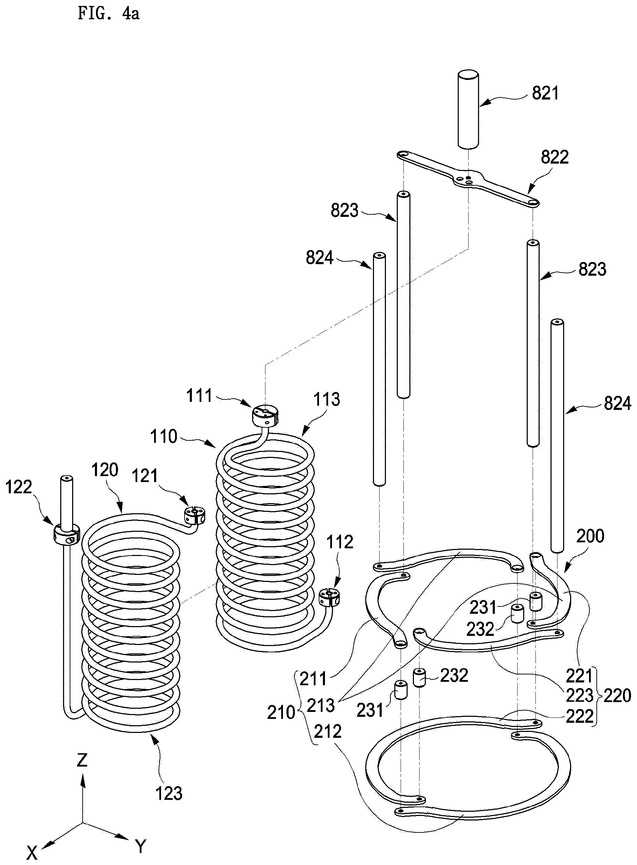

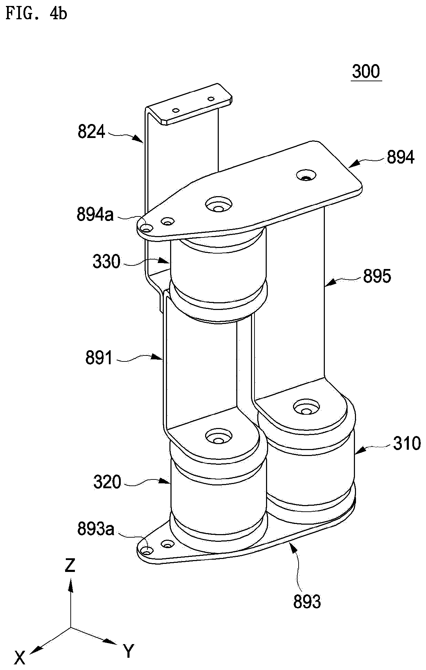

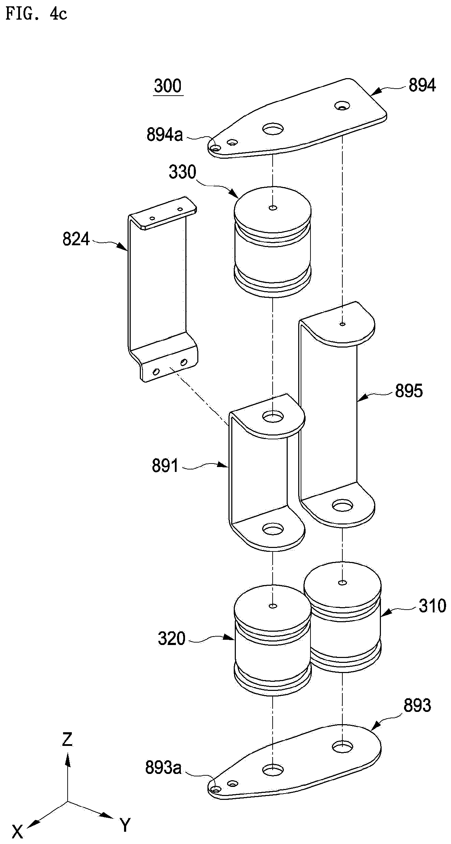

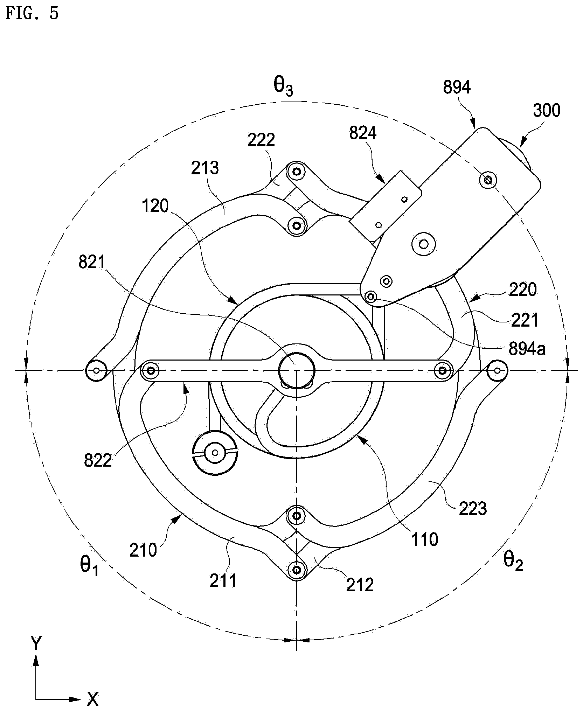

As shown in FIGS. 1 to 6, the antenna module according to the present invention is a component installed in a substrate processing apparatus or the like that performs substrate processing using plasma to form an induced electric field. It is characterized by comprising: a first antenna coil part 110, one end 111 of which is connected to a matcher 92; a second antenna coil part 120, the other end 122 of which is grounded; and a phase changing circuit part 300, one end 301 of which is connected to the other end 112 of the first antenna coil part 110 and the other end 302 of which is connected to one end 121 of the second antenna coil part 120, wherein the phase changing circuit part changes the phase of a first current flowing through the first antenna coil part 110 with a second current having a phase opposite to the first current.

The first antenna coil part 110 is a component whose one end 111 is connected to the matcher 92 and whose other end is connected to one end of the phase changing circuit part 300, and various configurations are possible.

The second antenna coil part 120 is a component whose other end 122 is grounded and whose one end is connected to the other end of the phase changing circuit part 300, and various configurations are possible.

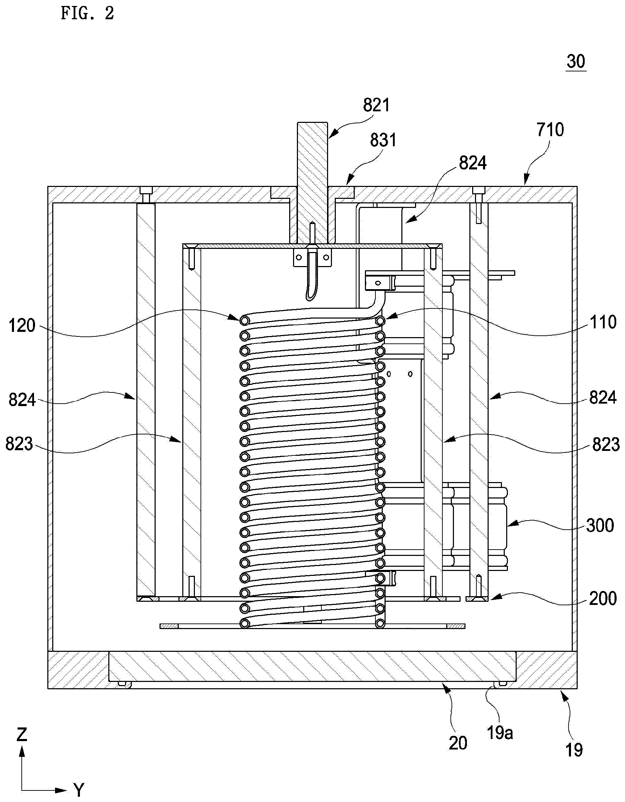

In particular, rather than being installed independently, the first antenna coil part 110 and the second antenna coil part 120, as shown in FIGS. 2 to 6, may be configured with coils 113, 123, wherein one end 111 and the other end 112 of the first antenna coil part 110 are disposed opposite to one end 121 and the other end 122 of the second antenna coil part 120, and are wound in the same direction with a vertical gap.

In particular, the first antenna coil part 110 and the second antenna coil part 120 may form a helical shape with the same center and radius.

Specifically, the first antenna coil part 110 and the second antenna coil part 120 have a helical structure with the same center and radius and may be formed in a coil structure with the same pitch vertically.

And both ends of the coils 113, 123 may be provided with a coupling structure for coupling with a power application member 821 described later, coupling with the phase changing circuit part 300, and coupling with a grounding member.

Meanwhile, the first antenna coil part 110 may be connected by various structures to a power application member 821 connected to a matcher 92, which is connected to an RF generator 91.

For example, considering that the first antenna coil part 110 forms a helical structure, one end 111 of the first antenna coil part 110 may be connected to a power application member 821 that extends toward the center of the helical shape forming the antenna coil part 110.

At this time, the power application member 821 may be installed to pass through a shielding housing 710 and is electrically insulated from the shielding housing 710 by an insulating member 831.

And when the ICP antenna module 30 according to the present invention further includes an outer antenna part 200 described later, a branch member 822 may be coupled for electrical connection with the outer antenna part 200.

The branch member 822 is a member coupled to the power application member 821 for electrical connection with the outer antenna part 200, and various configurations are possible, such as being configured in a '-' shape across the center of the first antenna coil part 110, depending on the number and structure of the outer antenna part 200 installed.

Meanwhile, the other end of the second antenna coil part 120 can be grounded by various structures.

For example, the other end of the second antenna coil part 120 may extend upward from the outer periphery of the helical structure at the lowermost end of the helical structure with a gap, and then be coupled to a shielding housing 710 described later to be grounded.

At this time, the other end of the second antenna coil part 120 may be coupled to the shielding housing 710 by a separate connecting conductor rod to the shielding housing 710.

Meanwhile, it is necessary to expand the planar size of the region where the induced electric field is formed by the first antenna coil part 110 and the second antenna coil part 120.

Accordingly, the ICP antenna module according to the present invention may further include one or more outer antenna parts 200 forming an outer helical shape with a radius larger than the radius of the first antenna coil part 110 and the second antenna coil part 120.

The one or more outer antenna parts 200 form an outer helical shape with a radius larger than the radius of the first antenna coil part 110 and the second antenna coil part 120, and various configurations are possible.

For example, the outer antenna part 200 may include n outer antenna coils 210, 220, wherein the positions of their one ends are arranged with a phase difference of 360°/n (where n is a natural number of 2 or more) along the circumferential direction.

More specifically, the outer antenna coils 210, 220 may include: a first antenna coil member 211, 221, one end of which is connected to a branch power application member 823 and has a first circumferential angle θ1; a second antenna coil member 212, 222, one end of which is connected to the other end of the first antenna coil member 211, 221, is installed lower than the first antenna coil member 211, 221, and has a second circumferential angle θ2; and a third antenna coil member 213, 223, one end of which is connected to the other end of the second antenna coil member 212, 222, is installed higher than the second antenna coil member 212, 222, and has a third circumferential angle θ3.

The first antenna coil member 211, 221, the second antenna coil member 212, 222, and the third antenna coil member 213, 223 are antenna members forming an outer helical shape with a radius larger than the radius of the first antenna coil part 110 and the second antenna coil part 120, and may form a coil shape or be configured as a plate-like member as shown in FIGS. 2 to 5.

And the first circumferential angle θ1, the second circumferential angle θ2, and the third circumferential angle θ3 can be variously set according to the number of installed outer antenna coils 210, 220, etc.

For example, the outer antenna coils 210, 220 may be arranged in a pair, similar to the first antenna coil part 110 and the second antenna coil part 120.

And the sum of the first circumferential angle θ1, the second circumferential angle θ2, and the third circumferential angle θ3 may be 360°/m (where m is a natural number of 1 or more).

Meanwhile, as an embodiment, the first circumferential angle θ1, the second circumferential angle θ2, and the third circumferential angle θ3 may have circumferential angles of 90°, 90°, and 180°, respectively.

And the first antenna coil member 211, 221 and the third antenna coil member 213, 223 are installed at the same height from the upper surface of a dielectric window 20 described later, and the second antenna coil member 212, 222 may be located at a lower position than the first antenna coil member 211, 221 and the third antenna coil member 213, 223.

And the first antenna coil member 211, 221, the second antenna coil member 212, 222, and the third antenna coil member 213, 223 are each configured as a plate-like member of metal material for convenience of assembly, and may be assembled by bolts with a conductive member interposed.

And the first antenna coil member 211, 221 is connected by the aforementioned branch member 822 and a branch power application member 823.

The branch power application member 823 is a metal member whose one end is connected to the branch member 822 and whose other end is connected to the first antenna coil member 211, 221, and can form various structures such as a rod.

Meanwhile, the third antenna coil member 213, 223 can be grounded by various structures by a separate conductive member.

For example, the third antenna coil member 213, 223 may be grounded by being connected to a grounding member 824 that connects the shielding housing 710.

The grounding member 824 has a configuration where one end is connected to the other end of the third antenna coil member 213, 223 and the other end is connected to the shielding housing 710, and various configurations such as a rod shape are possible.

At this time, the grounding member 824, as a rod structure, may be installed parallel to the branch power application member 823.

The phase changing circuit part 300 is a component whose one end 301 is connected to the other end 112 of the first antenna coil part 110 and whose other end 302 is connected to one end 121 of the second antenna coil part 120, and which changes the phase of a first current flowing through the first antenna coil part 110 with a second current having an opposite phase, and various configurations are possible.

The phase changing circuit part 300 can be configured by a combination of capacitors, reactances, etc., according to the power distribution, phase difference, etc., of the first antenna coil part 110 and the second antenna coil part 120, and various configurations are possible.

For example, it may be configured to include: a first capacitor 310 connecting the other end 112 of the first antenna coil part 110 and one end 121 of the second antenna coil part 120; and a second capacitor 320 and a third capacitor 330 connected in series between the other end 112 of the first antenna coil part 110 and one end 121 of the second antenna coil part 120, in parallel with the first capacitor 310, wherein a connecting conductive member 891 connecting the second capacitor 320 and the third capacitor 330 is grounded by a grounding conductive member 824.

The first capacitor 310, the second capacitor 320, and the third capacitor 330 are characterized by changing the phase of a first current flowing through the first antenna coil part 110 to a second current with an opposite phase, and may have appropriate capacitance values so that the first current and the second current have a preset phase difference, for example, a phase difference of 180°.

In addition, the first capacitor 310, the second capacitor 320, and the third capacitor 330 may be variable elements with variable capacitance values.

Meanwhile, the first capacitor 310 and the second capacitor 320 are connected to a first conductive member 893 connected to the other end 112 of the first antenna coil part 110, and the other end of the third capacitor 330, one end of which is connected to the connecting conductive member 891, and the other end of a third conductive member 895, one end of which is connected to the other end of the first capacitor 310, may be connected by a second conductive member 894 connected to one end 121 of the second antenna coil part 120.

The first conductive member 893, the second conductive member 894, the third conductive member 895, and the connecting conductive member 891 are components for electrically connecting the first antenna coil part 110, the second antenna coil part 120, the first capacitor 310, the second capacitor 320, and the third capacitor 330 according to the circuit configuration, and may be configured by a rigid metal plate to also support the first capacitor 310, the second capacitor 320, and the third capacitor 330.

In particular, the first conductive member 893, the second conductive member 894, the third conductive member 895, and the connecting conductive member 891 may be formed by bending a part of a flat plate so that the part connected to the first capacitor 310, the second capacitor 320, and the third capacitor 330 becomes a flat plate and they can be connected and arranged in a vertical direction as a whole.

Specifically, the first conductive member 893 is connected to the other end 112 of the first antenna coil part 110, and also to one end of the first capacitor 310 and the second capacitor 320, and may be configured as a flat plate.

And one end thereof may be provided with a coil connection part 893c for connection with the other end 112 of the first antenna coil part 110.

Meanwhile, the third capacitor 330 is connected in series by the aforementioned connecting conductive member 891, and the connecting conductive member 891 may be configured as a 'U'-shaped metal plate so that one end is coupled to the other end of the second capacitor 320 and one end of the third capacitor 330.

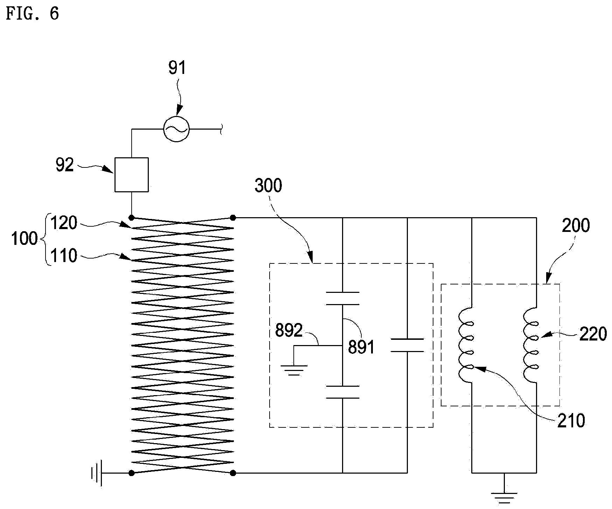

Meanwhile, the connecting conductive member 891 is grounded by a grounding conductive member 824, as in the equivalent circuit shown in FIG. 6.

The grounding conductive member 824 can ground the connecting conductive member 891 by having one end connected to the connecting conductive member 891 and the other end grounded.

In particular, the grounding conductive member 824 can be grounded by being connected to the grounded shielding housing 710.

Specifically, it can be configured as a metal plate bent several times so that one end is surface-contacted and coupled to the plate surface of the metal plate forming the connecting conductive member 891 and the other end is surface-contacted and coupled to the shielding housing 710.

The second conductive member 894 is a component coupled to the other end of the third conductive member 895 and the other end of the third capacitor 330, and also connected to one end 121 of the second antenna coil part 120, and various configurations are possible.

For example, the second conductive member 894 may have a shape similar to or the same as the first conductive member 893, and may be configured as a flat plate to which the other end of the third conductive member 895 and the other end of the third capacitor 330 are coupled.

And one end thereof may be provided with a coil connection part 894a for connection with one end 121 of the second antenna coil part 120.

The third conductive member 895 is a component whose one end is connected to the other end of the first capacitor 310 and whose other end is connected to the second conductive member 894, and may be configured as a metal plate bent several times.

To summarize, the connecting conductive member 891, the first conductive member 893, the second conductive member 894, and the third conductive member 895 may be formed by a metal plate bent one or more times according to the installation position.

FIG. 6 is a conceptual diagram showing an equivalent circuit of the ICP antenna module according to the present invention.

Meanwhile, the ICP antenna module according to the present invention having the above configuration may be covered by a shielding housing 710 for shielding the induced electric field.

The shielding housing 710 is a component that covers the first antenna coil part 110, the second antenna coil part 120, and the phase changing part 300 for shielding the induced electric field, and any configuration and structure are possible as long as they can block the leakage of the induced electric field formed in the first antenna coil part 110 and the second antenna coil part 120 to the surroundings.

With the above configuration, the substrate processing apparatus and the ICP antenna module used therein according to the present invention can greatly improve the uniformity of substrate processing by ultimately improving plasma uniformity by including a pair of coils wound in opposite directions.

Meanwhile, the ICP antenna module 30 according to the present invention can be applied to any structure using an induced electric field as it enables the formation of a uniform induced electric field.

For example, the ICP antenna module 30 according to the present invention can be applied as an antenna module in a substrate processing apparatus including a chamber body 10 with an open top, a substrate support 12 installed in the chamber body 10 on which a substrate 1 is seated, a dielectric window 20 coupled to the upper opening of the chamber body 10 to form a sealed processing space S, and an ICP antenna module 30 installed on the upper side of the dielectric window 20 to form an induced electric field, such as the substrate processing apparatus presented in Patent Document 1.

The above is a description of only some of the preferred embodiments that can be implemented by the present invention, and as is well known, the scope of the present invention should not be interpreted as being limited to the above embodiments, and all technical ideas that share the fundamental technical spirit of the present invention described above shall be included in the scope of the present invention.

## Claims

1. An ICP antenna module (30), comprising:
a first antenna coil part (110), one end (111) of which is connected to a matcher (92);
a second antenna coil part (120), the other end (122) of which is grounded; and
a phase changing circuit part (300), one end (301) of which is connected to the other end (112) of the first antenna coil part (110) and the other end (302) of which is connected to one end (121) of the second antenna coil part (120), wherein the phase changing circuit part (300) changes a phase of a first current flowing through the first antenna coil part (110) to a second current having a phase opposite to the first current.

2. The ICP antenna module of claim 1, wherein the first antenna coil part (110) and the second antenna coil part (120) are configured as a coil, wherein one end (111) and the other (112) end of the first antenna coil part (110) are disposed opposite to one end (121) and the other end (122) of the second antenna coil part (120), and are wound in the same direction with a vertical gap.

3. The ICP antenna module of claim 2, wherein the first antenna coil part (110) and the second antenna coil part (120) form a helical shape with the same center and radius.

4. The ICP antenna module of claim 2, further comprising at least one outer antenna part (200) forming an outer helical shape with a radius larger than the radius of the first antenna coil part (110) and the second antenna coil part (120).

5. The ICP antenna module of claim 4, wherein the outer antenna part (200) comprises n outer antenna coils (210, 220), wherein the positions of one ends thereof are arranged with a phase difference of 360°/n, where n is a natural number of 2 or more, along a circumferential direction.

6. The ICP antenna module of claim 5, wherein the outer antenna coil (210; 220) comprises:
a first antenna coil member (211; 221), one end of which is connected to a branch power application member (823) and has a first circumferential angle (θ1);
a second antenna coil member (212; 222), one end of which is connected to the other end of the first antenna coil member (211; 221), is installed lower than the first antenna coil member (211; 221), and has a second circumferential angle (θ2); and
a third antenna coil member (213; 223), one end of which is connected to the other end of the second antenna coil member (212; 222), is installed higher than the second antenna coil member, and has a third circumferential angle (θ3),
wherein a sum of the first circumferential angle (θ1), the second circumferential angle (θ2), and the third circumferential angle (θ3) is 360°.

7. The ICP antenna module of any one of claims 1 to 6, wherein the phase changing circuit part (300) comprises:
a first capacitor (310) connecting the other end (112) of the first antenna coil part (110) and one end (121) of the second antenna coil part (120); and
a second capacitor (320) and a third capacitor (330) connected in series between the other end (112) of the first antenna coil part (110) and one end (121) of the second antenna coil part (120), in parallel with the first capacitor (310),
wherein a connecting conductive member (891) connecting the second capacitor (320) and the third capacitor (330) is grounded by a grounding conductive member (824).

8. The ICP antenna module of claim 7, wherein the first capacitor (310) and the second capacitor (320) are connected to a first conductive member (893) connected to the other end (112) of the first antenna coil part (110), and
the other end of the third capacitor (330), one end of which is connected to the connecting conductive member (891), and the other end of a third conductive member (895), one end of which is connected to the other end of the first capacitor (310), are connected by a second conductive member (894) connected to one end (121) of the second antenna coil part (120).

9. The ICP antenna module of claim 8, wherein the connecting conductive member (891), the first conductive member (893), the second conductive member (894), and the third conductive member (895) are formed by a metal plate.

10. The ICP antenna module of any one of claims 1 to 6, wherein one end (111) of the first antenna coil part (110) is connected to a power application member (821) extending toward a center of a helical shape that forms the first antenna coil part (110).

11. A substrate processing apparatus, comprising:
a chamber body (10) having an open top;
a substrate support (12) installed in the chamber body (10), on which a substrate (1) is seated;
a dielectric window (20) coupled to the upper opening of the chamber body (10) to form a sealed processing space (S); and
an ICP antenna module (30) installed on an upper side of the dielectric window (20) to form an induced electric field,
wherein the ICP antenna module is the antenna module (30) according to any one of claims 1 to 6.

12. The substrate processing apparatus of claim 11, wherein the phase changing circuit part (300) comprises:
a first capacitor (310) connecting the other end (113) of the first antenna coil part (110) and one end (121) of the second antenna coil part (120); and
a second capacitor (320) and a third capacitor (330) connected in series between the other end (112) of the first antenna coil part (110) and one end (121) of the second antenna coil part (120), in parallel with the first capacitor, (310)
wherein a connecting conductive member (891) connecting the second capacitor (320) and the third capacitor (330) is grounded by a grounding conductive member (824).

13. The substrate processing apparatus of claim 12, wherein the first capacitor (310) and the second capacitor (320) are connected to a first conductive member (893) connected to the other end (112) of the first antenna coil part (110), and
the other end of the third capacitor (330), one end of which is connected to the connecting conductive member (891), and the other end of a third conductive member (895), one end of which is connected to the other end of the first capacitor (310), are connected by a second conductive member (894) connected to one end (121) of the second antenna coil part (120).

14. The substrate processing apparatus of claim 13, wherein the connecting conductive member (891), the first conductive member (893), the second conductive member (894), and the third conductive member (895) are formed by a metal plate.

15. The substrate processing apparatus of claim 11, wherein one end (11) of the first antenna coil part (110) is connected to a power application member (821) extending toward a center of a helical shape that forms the first antenna coil part (110).
